# EUROPÄISCHE PATENTSCHRIFT

(11) **EP 0 418 250 B1**
(45) Veröffentlichungstag und Bekanntmachung des Hinweises auf die Patenterteilung: **27.01.1993**
(21) Anmeldenummer: 89904769.0
(22) Anmeldetag: 27.04.1989
(51) Int. Cl.: B25J 7/00, B25J 9/10, B25J 9/12, B23Q 5/50

(54) **MIKROMANIPULATOR ZUR BEWEGUNG VON OBJEKTEN**
MICROMANIPULATOR FOR MOVING OBJECTS
MICROMANIPULATEUR POUR DEPLACER DES OBJETS

(30) Priorität: 29.04.1988 DE 3814616
(43) Veröffentlichungstag der Anmeldung: 27.03.1991
(73) Patentinhaber: FRAUNHOFER-GESELLSCHAFT ZUR FÖRDERUNG DER ANGEWANDTEN FORSCHUNG E.V., 80636 München (DE)
(72) Erfinder: BENECKE, Wolfgang, D-1000 Berlin 30 (DE)
(74) Vertreter: Münich, Wilhelm, Dr.
(86) Internationale Anmeldenummer: DE8900271
(87) Internationale Veröffentlichungsnummer: WO8910241

(56) Entgegenhaltungen:
- EP-A- 0 085 745
- WO-A-88/04599
- FR-A- 2 235 416

## Beschreibung

Die Erfindung betrifft einen Mikromanipulator zur Bewegung von Objekten, insbesondere zur Bewegung kleiner Objekte über mikroskopische Entfernungen. Die Präzision der für Bewegungen häufig eingesetzten feinmechanischen Stellelemente, die mit Mikrometerschrauben ausgerüstet sind, reicht bei den Bewegungsabläufen in der modernen Mikrotechnologie oft nicht aus. Auch für Anwendungen in Hochvakua und anderen abgeschlossenen Systemen, bei denen mechanische Durchführungen Störquellen darstellen, sind diese Stellelemente ungeeignet. Für solche Anwendungen eignen sich besser Stellelemente, die elektromagnetisch betrieben werden oder auf dem piezoelektrischen Effekt basieren.

### Stand der Technik

Ein Mikromanipulator, bei welchem zur Bewegung von Objekten piezoelektrische Bewegungselemente verwendet werden, ist in der DE-OS 36 10 540 beschrieben. Durch die mit dem piezoelektrischen Effekt erreichbare Verformung der Bewegungselemente sind diesen Mikromanipulatoren in zweifacher Hinsicht Grenzen gesetzt. Zum einen sind die einzelnen Bewegungsschritte auf den nm-Bereich begrenzt, so daß für die Bewegung über größere Entfernungen hinweg sehr viele Schritte durchgeführt werden müssen. Zum anderen dürfen die einzelnen Bewegungselemente nicht zu klein dimensioniert werden, da mit abnehmender Größe die maximal erzielbare Schrittweite verringert wird. Die Miniaturisierung des Manipulators ist dadurch eingeschränkt.

### Darstellung der Erfindung

Aufgabe der Erfindung ist es, einen Mikromanipulator zur Bewegung von Objekten anzugeben, der bei hoher Präzision der Bewegung und hohem Grad an Miniaturisierung variable Schrittweiten bis in den Bereich von ca. 100 µm zuläßt.

Diese Aufgabe wird erfindungsgemäß dadurch gelöst, daß die mechanischen Elemente des Mikromanipulators als bewegliche Zungen ausgebildet sind, die aus übereinander angeordneten Schichten verschiedener Materialien mit unterschiedlichen thermischen Ausdehnungskoeffizienten bestehen, und einseitig an einem Grundkörper angebracht sind, und auf deren losen Enden das zu bewegende Objekt oder ein Objektträger aufliegt, und daß zur Erwärmung der Zungen Wärmequellen vorgesehen sind.

Die Zungen werden durch Zuführung von Energie erhitzt. Da eine Zunge aus wenigstens zwei Schichten mit unterschiedlichen thermischen Ausdehnungskoeffizienten zusammengesetzt ist, führt die Erwärmung zu einer Verbiegung der Zunge. Durch geeignete Koordination der Bewegungen mehrerer Zungen eines Mikromanipulators können Objekte bewegt werden.

Vorteilhafte Ausgestaltungen der Erfindung sind in den Unteransprüchen gekennzeichnet. Um eine lineare Bewegung eines Objektes zu erreichen, sind die Zungen nach Anspruch 2 paarweise so angeordnet, daß sich jeweils zwei Zungen um 180° verdreht einander gegenüberliegen.

Nach Anspruch 3 besteht der Grundkörper des Mikromanipulators aus Silizium. Damit findet als Ausgangsmaterial ein in der industriellen Mikroelektronik weit verbreiteter Stoff Anwendung. Um mit geringen Heizleistungen möglichst große Bewegungsschritte zu erzielen, besteht die Zunge aus einer Kombination von Materialien mit möglichst unterschiedlichen thermischen Ausdehnungskoeffizienten. Die Kombination einer Schicht aus Siliziumverbindung (z.B. Siliziumnitrit oder Siliziumdioxid) und einer Metallschicht kommt den Fertigungsverfahren der Mikrostrukturtechnik entgegen.

Die Temperaturerhöhung erfolgt nach Anspruch 4 mittels Heizelementen, sie könnte aber prinzipiell auch mit anderen Methoden, z.B. thermische Strahlung, erreicht werden. Nach Anspruch 5 sind die Heizelemente vorteilhaft als elektrische Widerstände ausgebildet, und zur Gewährleistung einer gleichmäßigen Erwärmung zwischen oder auf den Schichten angebracht.

Um Einflüsse der Umgebungstemperatur auf die Lage der Zungen auszuschließen, ist in Anspruch 6 eine besonders günstige Anordnung gekennzeichnet, bei welcher zur Erfassung der momentanen Position und zur Positionsregelung Sensorelemente auf den Zungen angebracht sind. Sie können auf verschiedenen physikalischen Effekten beruhen. Die Verwendung von Piezowiderständen ist besonders vorteilhaft, da der statische piezoresistive Effekt bei Silizium besonders gut ausgeprägt ist, und die Lage der Zungen unmittelbar über die Messung der Zug- oder Druckbelastungen bestimmt werden kann. Ein weiterer Vorzug besteht darin, daß Piezowiderstände einfach mit Hilfe der in der Mikroelektronik üblichen Techniken herstellbar sind. Die Heizer- und Sensorsignale werden in gemeinsamen Regelkreisen miteinander verknüpft, wodurch die Zungen beispielsweise durch Regelung der Heizleistung in vorgebbare Positionen gebracht werden können. Damit lassen sich sowohl die Bewegungen der Zungen koordinieren, als auch die Schrittweite bestimmen. Der Aufbau und die Wirkungsweise der einzelnen Greifelemente entspricht dem des steuerbaren positionsveränderlichen Elementes, das in der unveröffentlichten deutschen Anmeldung DE-A-38 09 597.1 beschrieben ist.

Um einen hohen Grad an Miniaturisierung zu erreichen, sind nach Anspruch 7 die Regelkreise und der Mikromanipulator auf demselben Halbleiterchip integriert. Dadurch können Mikromanipulatoren hergestellt werden, die aus einer Vielzahl von identischen Zungen bestehen, wodurch komplizierte Bewegungsabläufe auch über eine Entfernung von vielen Schrittweiten hinweg möglich werden.

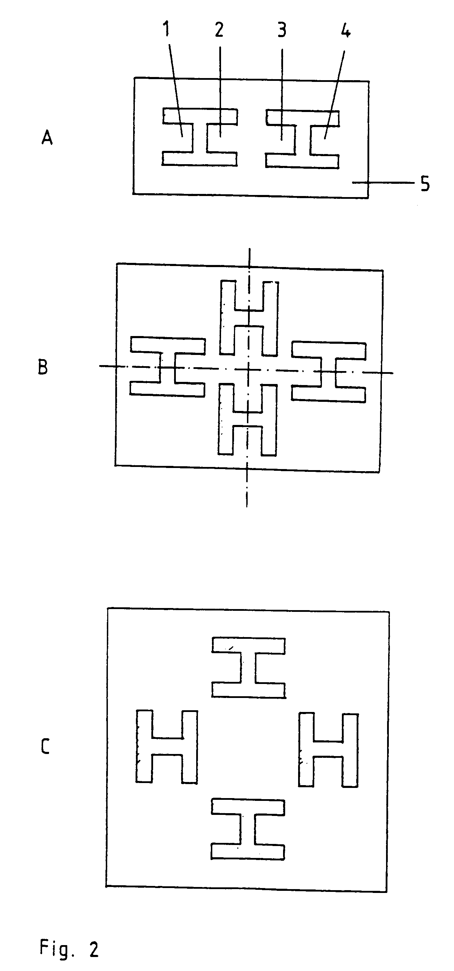

Werden - wie in Anspruch 8 gekennzeichnet - die Zungenpaare entlang einer Linie angeordnet, können Objekte in eindimensionaler Richtung bewegt werden (Fig. 2A). Durch Anordnung der Zungenpaare entlang mehrerer paralleler Linien kann das zu transportierende Gewicht gesteigert werden.

Nach Anspruch 9 sind die Zungenpaare entlang zweier Scharen paralleler Linien, die sich schneiden angeordnet. Diese Ausgestaltung der Erfindung erlaubt eine beliebige Bewegung in einer Ebene. Eine Drehbewegung kann durch eine Anordnung der Zungen entlang konzentrischer Kreislinien nach Anspruch 10 erreicht werden, wobei die Drehachse senkrecht auf der Ebene steht, in welcher die Zungenpaare angeordnet sind.

Darüber hinaus ist auch eine Kippbewegung um kleine Winkel möglich, indem die losen Zungenenden, die den Objektträger an verschiedenen Stellen unterstützen, unterschiedlich weit vom Grundkörper wegbewegt werden. Durch eine gleichzeitige Auslenkung aller Zungen kann das Objekt in begrenztem Umfange auch senkrecht zu der Ebene bewegt werden, in welcher die Zungen angeordnet sind. Diese Bewegung, die durch die Länge der Zungen begrenzt wird, ist von großem Vorteil, wenn das Objekt beispielsweise in den Fokus eines Licht- oder Elektronenstrahls justiert werden soll. Alle gekennzeichneten Weiterbildungen der Erfindung werden nach dem Anspruch 11 vorteilhaft mit den in der Mikromechanik und in der Mikroelektronik bekannten Verfahren hergestellt und sind mit Standard-IC-Prozessen kompatibel. Die einzelnen Bestandteile werden dabei mit Hilfe planarer Lithographieprozesse strukturiert. Für den Betrieb eines Mikromanipulators reichen die in der Mikroelektronik üblichen Spannungspegel aus.

Der erfindungsgemäße Mikromanipulator und seine Weiterbildungen zeichen sich durch einen hohen Grad an Miniaturisierung, hohe Genauigkeit, große Zuverlässigkeit und niedrige Kosten aus. Er eignet sich besonders für die Bewegung von Objekten in abgeschlossenen Systemen, bei welchen mechanische Durchführungen vermieden werden müssen, beispielsweise in Ultrahochvakuum-Apparaturen (z.B. Rasterelektronenmikroskopie). Der extreme Grad an Miniaturisierung erlaubt den Einsatz bei Mikrohandhabungssystemen und jeder Art von Objektbewegung bei mikroskopischen Untersuchungen, bei der Bearbeitung oder Analyse von Objekten in der Mikrotechnologie oder in der Mikrobiologie.

### Kurze Beschreibung der Zeichnung

Nachfolgend werden anhand von Zeichnungen drei Ausführungsbeispiele und das Funktionsprinzip des Mikromanipulators dargestellt.

Es zeigen:
Fig. 1 A bis E das Funktionsprinzip des Mikromanipulators,
Fig. 2A Schematisierte Darstellung des Mikromanipulators für eindimensionale Translationen,
B Schematische Darstellung des Mikromanipulators für beliebige Bewegungen in einer Ebene,
C Schematische Darstellung des Mikromanipulators für Drehbewegungen.

### Weg zur Ausführung der Erfindung

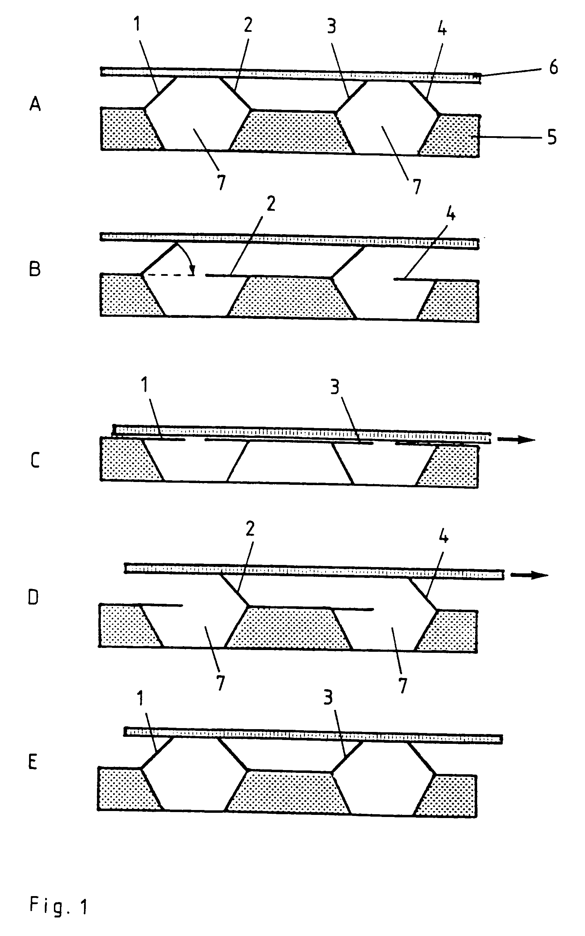

Der Mikromanipulator in Fig. 1A besitzt einen Grundkörper 5 aus einkristallinem Silizium (Dicke ca. 0,5 mm), wobei vorteilhaft ein in der Mikroelektronik üblicher Siliziumwafer verwendet wird. Der Manipulator weist in seiner einfachsten Ausgestaltung vier Zungen 1, 2, 3, 4 mit einer Länge von einigen hundert Mikrometern auf, die aus einer epitaktisch abgeschiedenen hoch-bordotierten Siliziumschicht (Dicke einige µm) und einer aufgedampften Metallschicht (vorzugsweise Gold, Dicke einige µm) zusammengesetzt sind. Die Zungen sind durch Lithographieprozesse definiert und mit Hilfe anisotroper Ätzschritte unter Bildung von Ätzgruben 7 vom Grundkörper freigelegt. Die Goldschicht ist so aufgebracht, daß sie eine Zugspannung verursacht, so daß die Zungen im Ruhestand (ohne Energieeinspeisung) aus den Ätzgruben herausragen.

Auf den freien Enden der Zungen 1, 2, 3, 4 liegt das Objekt bzw. der Objektträger 6. Um den Objektträger zu bewegen, werden die Zungen 2 und 4 so ausgelenkt, daß sie in der Ebene der Oberfläche des Grundkörpers 5 liegen (Fig. 1B). Durch Auslenken der Zungen 1 und 3 in Richtung der Ätzgruben 7 bewegt sich das Objekt in der in Fig. 1C angegebenen Richtung. Durch Auslenken der Zungen 2 und 4 aus den Ätzgruben 7 heraus wird das Objekt in derselben Richtung weiterbewegt (Fig. 1D). Wird schließlich das Zungenpaar 1, 3 wieder in seine Ausgangslage gebracht, so ist der ursprüngliche Zustand erreicht, mit dem Unterschied, daß der Objektträger gegenüber seiner Ausgangsposition verschoben ist (Fig. 1E).
Durch Umkehren der Zungenansteuersequenz kann die Bewegungsrichtung des Objektes umgedreht werden. Das Ausmaß der ursprünglichen Auslenkung der Zungen bestimmt den bei einem Schritt zurückgelegten Weg. Damit ist die Schrittweite in einem großen Umfang regelbar (bis zu etwa 100 µm).

Mit Hilfe des Mikromanipulators kann der Winkel zwischen dem Objektträger und der Substratoberfläche verändert werden. Um den Objektträger zu kippen bleibt die Zunge 1 ausgelenkt, während die Zungen 2, 3 und 4 in die Oberfläche des Grundkörpers abgesenkt werden.

In begrenztem Umfang kann der Objektträger senkrecht zu seiner Oberfläche bewegt werden. Hierzu werden alle Zungen 1, 2, 3 und 4 parallel im selben Maße ausgelenkt. Mit dieser Bewegung kann eine Feinjustierung von Objekten durchgeführt werden.

In Fig. 2A ist der Mikromanipulator aus Fig. 1 schematisch in der Draufsicht dargestellt. Die lineare Anordnung der Zungenpaare 1, 2 und 3, 4 führt bei der oben beschriebenen Ansteuerung zu einer linearen Bewegung des Objekts. Durch Hintereinanderschalten mehrerer Zungenpaare kann das Objekt über größere Distanzen transportiert werden.

In Fig. 2B sind die Zungenpaare entlang zweier sich schneidender Linien angeordnet. Dadurch kann das Objekt in zwei Richtungen einer Ebene bewegt werden. Bei einer nicht abgebildeten Weiterbildung der Erfindung sind viele Zungenpaare entlang zweier Scharen sich schneidender Geraden angeordnet. Durch geeignete Aneinanderreihung von linearen Bewegungen entlang der unterschiedlichen Richtungen der Geraden-Scharen wird das Objekt an jeden beliebigen Ort in der Ebene transportiert.

Die Anordnung der Zungenpaare entlang einer Kreislinie nach Fig. 2C führt bei geeigneter Koordinierung der Bewegung aller Paare zu einer Rotationsbewegung. Um eine möglichst gleichmäßige Rotationsbewegung zu erreichen werden mehrere Zungenpaare entlang einer Kreislinie oder entlang konzentrischer Kreislinien angeordnet.

Bei der Bewegung von Objekten, deren Dimensionen ein vielfaches der Größe eines Zungenpaares einnimmt, wird die Last auf viele Zungen verteilt. Entsprechend viele Zungen werden zur Durchführung der Bewegung simultan angesteuert.

## Patentansprüche

1. Mikromanipulator zur Bewegung von Objekten mit mechanischen Elementen, dadurch **gekennzeichnet**, daß die mechanischen Elemente als bewegliche Zungen (1, 2, 3 und 4) ausgebildet sind, die aus übereinander angeordneten Schichten verschiedener Materialien mit unterschiedlicher thermischer Ausdehnung bestehen, und einseitig an einem Grundkörper (5) angebracht sind, und auf deren losen Enden das zu bewegende Objekt oder ein Objektträger (6) aufliegt, und daß zur Erwärmung der Zungen Wärmequellen vorgesehen sind.

2. Mikromanipulator zur Bewegung von Objekten nach Anspruch 1, dadurch **gekennzeichnet**, daß jeweils zwei Zungen (z.B. 1 und 2) 180° gegeneinander verdreht paarweise angeordnet sind.

3. Mikromanipulator zur Bewegung von Objekten nach den Ansprüchen 1 und 2, dadurch **gekennzeichnet**, daß der Grundkörper (5) des Mikromanipulators aus Silizium und die Zungen aus einer Schicht aus einer Siliziumverbindung und einer Metallschicht bestehen.

4. Mikromanipulator zur Bewegung von Objekten nach einem der Ansprüche 1 bis 3, dadurch **gekennzeichnet**, daß auf den Zungen Heizelemente angebracht sind.

5. Mikromanipulator zur Bewegung von Objekten nach Anspruch 4, dadurch **gekennzeichnet**, daß die Heizelemente als elektrische Widerstände ausgebildet und zwischen oder auf den Schichten der Zungen angeordnet sind.

6. Mikromanipulator zur Bewegung von Objekten nach einem der Ansprüche 1 bis 5, dadurch **gekennzeichnet**, daß auf den Zungen zur Positionserfassung und Positionsregelung Sensorelemente angebracht sind, daß die Sensorelemente als Piezowiderstände ausgebildet sind, oder auf magnetischen, piezoelektrischen, ferroelektrischen oder kapazitiven Effekten beruhen und daß die Heizelemente und die Sensorelemente über gemeinsame elektrische Regelkreise miteinander verknüpft sind.

7. Mikromanipulator zur Bewegung von Objekten nach einem der Ansprüche 1 bis 6, dadurch **gekennzeichnet**, daß alle mechanischen und alle elektrischen Komponenten auf einem Halbieiterchip integriert sind.

8. Mikromanipulator zur Bewegung von Objekten nach einem der Ansprüche 1 bis 7, dadurch **gekennzeichnet**, daß mehrere Paare von Zungen, die jeweils um 180° gegeneinander verdreht sind, entlang einer Linie oder entlang mehrerer paralleler Linien angeordnet sind.

9. Mikromanipulator zur Bewegung von Objekten nach einem der Ansprüche 1 bis 7, dadurch **gekennzeichnet**, daß mehrere Paare von Zungen, die jeweils um 180° gegeneinander verdreht sind entlang zweier sich schneidender Linien oder entlang zweier sich schneidender Scharen paralleler Linien angeordnet sind.

10. Mikromanipulator zur Bewegung von Objekten nach einem der Ansprüche 1 bis 7, dadurch **gekennzeichnet**, daß mehrere Zungenpaare entlang einer Kreistinie oder entlang konzentrischer Kreislinien angeordnet sind.

11. Verfahren zur Herstellung eines Mikromanipulators zur Bewegung von Objekten nach den Ansprüchen 1 bis 10, dadurch **gekennzeichnet**, daß die Strukturen der beweglichen Zungen mit planaren Lithographieprozessen definiert werden, und daß die in der Mikromechanik bekannten Verfahren, wie epitaktische Abscheidung, Ätzen mit definiertem Ätzstop und anisotropes Ätzen angewendet werden.

## Revendications

1. Micromanipulateur pour déplacer des objets, à des éléments mécaniques, **caractérisé** en ce que les éléments mécaniques sont conçus sous forme des lames mobiles (1, 2, 3 et 4) qui consistent en des couches superposées des matériaux qui présentent des coefficients de dilatation thermique différents, et qui sont unilatéralement fixés à un corps de base (5), pendant que l'objet à déplacer ou un porte-objet (6) se trouve sur les extrémités libres des lames, et en ce que des sources de chauffage sont prévues pour chauffer les lames.

2. Micromanipulateur pour déplacer des objets selon la revendication 1, **caractérisé** en ce que deux lames respectives (p.e. 1 et 2) sont disposées par paires et tournées par 180° l'une relativement à l'autre.

3. Micromanipulateur pour déplacer des objets selon les revendications 1 et 2, **caractérisé** en ce que ledit corps de base (5) of du micromanipulateur consiste en silicium et en ce que les lames consistent en une couche composée d'un composé de silicium et une couche métallique.

4. Micromanipulateur pour déplacer des objets selon une quelconque des revendications 1 à 3, **caractérisé** en ce que des éléments de chauffage sont prévus sur lesdites lames.

5. Micromanipulateur pour déplacer des objets selon la revendication 4, **caractérisé** en ce que lesdits éléments de chauffage sont conçus sous forme des résisteurs électriques et sont disposés entre ou sur les couches desdites lames.

6. Micromanipulateur pour déplacer des objets selon une quelconque des revendications 1 à 5, **caractérisé** en ce que des éléments détecteurs sont montés sur lesdites lames pour détecter et contrôler la position, en ce que lesdits éléments détecteurs sont réalisés sous forme des piézo-résisteurs ou fonctionnement à base des effets magnétiques, piézoélectriques, ferro-électriques ou capacitifs, et en ce que lesdits éléments de chauffage et lesdits éléments détecteurs sont enchaînés l'un avec l'autre par des boucles d'asservissement fermées électriques communes.

7. Micromanipulateur pour déplacer des objets selon une quelconque des revendications 1 à 6, **caractérisé** en ce que tous les éléments mécaniques et électriques sont intégrés sur une microplaquette semiconductrice.

8. Micromanipulateur pour déplacer des objets selon une quelconque des revendications 1 à 7, **caractérisé** en ce que plusieurs paires de lames, qui sont tournées par 180° l'une relativement à l'autre, sont disposées le long d'une ligne ou le long plusieurs lignes parallèles.

9. Micromanipulateur pour déplacer des objets selon une quelconque des revendications 1 à 7, **caractérisé** en ce que plusieurs paires de lames, qui sont tournées par 180° l'une relativement à l'autre, sont disposées le long deux lignes qui se coupent, ou le long deux systèmes de lignes parallèles, qui se coupent.

10. Micromanipulateur pour déplacer des objets selon une quelconque des revendications 1 à 7, **caractérisé** en ce que plusieurs paires de lames sont disposées le l'on d'un cercle ou le long des cercles concentriques.

11. Procédé de fabrication d'un micromanipulateur pour déplacer des objets selon les revendications 1 à 10, **caractérisé** en ce que les structures desdites lames mobiles sont définies au moyen de processus de lithographie planaire, et en ce que les techniques communes sur le plan de la micromécanique, p.e. le dépôt épitaxial, la gravure à arrêt défini de gravure, et la gravure anisotropique, sont appliquées.

## Claims

1. Micromanipulator for moving objects, having mechanical elements, **characterized** in that the mechanical elements are designed as movable blades (1, 2, 3 and 4) consisting of superimposed layers of different materials having different coefficients of thermal expansion, and are unilaterally attached to a base body (5), while the object to be moved or an object carrier (6) rests on the free ends of said blades, and that heat sources are provided for heating the blades.

2. Micromanipulator for moving objects according to Claim 1, **characterized** in that two blades respectively (e.g. 1 and 2) are disposed in pairs and rotated through 180° relative to one another.

3. Micromanipulator for moving objects according to Claims 1 and 2, **characterized** in that said base body (5) of the micromanipulator consists of silicon and that the blades consist of a layer composed of a silicon compound and a metal layer.

4. Micromanipulator for moving objects according to any of Claims 1 to 3, **characterized** in that heating elements are provided on the blades.

5. Micromanipulator for moving objects according to Claim 4, **characterized** in that said heating elements are configured as electrical resistors and are disposed between or on the layers of said blades.

6. Micromanipulator for moving objects according to any of Claims 1 to 5, **characterized** in that sensor elements are mounted on said blades for detecting and controlling the position, that said sensor elements are configured as piezo-resistors or operate on magnetic, piezoelectric, ferroelectric or capacitive effects, and that said heating elements and said sensor elements are combined with each other through common electrical control loops.

7. Micromanipulator for moving objects according to any of Claims 1 to 6, **characterized** in that all the mechanical and all the electrical components are integrated on a semiconductor chip.

8. Micromanipulator for moving objects according to any of Claims 1 to 7, **characterized** in that several pairs of blades, which are rotated through 180° relative to one another, are disposed along a line or along several parallel lines.

9. Micromanipulator for moving objects according to any of Claims 1 to 7, **characterized** in that several pairs of blades, which are rotated through 180° relative to one another, are disposed along two intersecting lines or along two intersecting families of parallel lines.

10. Micromanipulator for moving objects according to any of Claims 1 to 7, **characterized** in that several pairs of blades are disposed along a circle or along concentric circles.

11. Process for manufacturing a micromanipulator for moving objects according the Claims 1 to 10, **characterized** in that the structures of said movable blades are defined by means of processes of planar lithography, and that the techniques common in micromechanics, such as epitactical deposition, etching with a defined etching stop, and anisotropic etching, are employed.
